# EUROPEAN PATENT APPLICATION

(11) **EP 4 782 250 A1**
(43) Date of publication of application: **29.07.2026**
(21) Application number: 25218263.9
(22) Date of filing: 25.11.2025
(51) Int. Cl.: B60L 3/12, G01R 31/00, G01R 31/34

(54) **MOTOR EVALUATION INDEX PRESENTATION APPARATUS, MOTOR OUTPUT EVALUATION SYSTEM, AND MOTOR EVALUATION INDEX PRESENTATION METHOD**

(30) Priority: 27.11.2024 JP 2024205962
(71) Applicant: Independent Administrative Institution National Agency for Automobile and Land Transport Technology, Tokyo 160-0003 (JP)
(72) Inventor: TANAKA, Nobuhisa, Tokyo, 160-0003 (JP)
(74) Representative: TBK

(57) **Abstract**

A motor evaluation index presentation apparatus includes: an output measurement device (2) configured to measure an output (Pm) of an electric motor (210) or output (Pc) of the vehicle (200) on which the electric motor (210) is mounted, and/or a temperature measurement device (1) configured to measure surface temperature of the electric motor (210); and a margin data generator (3a) configured to generate and output margin determination data for determining magnitude of margin relative to the evaluation target output of the electric motor (210). The margin data generator (3a) is configured to, after the electric motor (210) is driven in an output range including the evaluation target output for a predetermined time, generate data on an amount of drop in the output (Pm) of the electric motor (210) or the output (Pc) of the vehicle (200) on which the electric motor (210) is mounted as the margin determination data if the output measurement device (2) is included, and generate data on the surface temperature of the electric motor (210) as the margin determination data if the temperature measurement device (1) is included.

## Description

### Technical Field

The present invention relates to a motor evaluation index presentation apparatus that presents an evaluation index for evaluating the output of an electric motor mounted on a vehicle, a motor output evaluation system including the same, and a motor evaluation index presentation method.

### Background Art

Small electric mobility devices such as electric kick scooters, minicars, and electric motorcycles have been attracting attention as new means of transportation in recent years. These types of transportation means are highly maneuverable due to their small size and have extremely high environmental performance due to being electric-powered, and are expected to see further widespread adoption in the future.

Electric motors mounted on electric mobility devices have a "rated output". The rated output is an index of whether the motor can withstand use for required work. For example, as described in Non-Patent Literature 1, a rated output test for determining whether an electric motor has output performance equal to or higher than its intended nominal power is known.

### Cited Documents

### Patent Literature

[Non-Patent Literature 1] National Agency of Automobile and Land Transport Technology (NALTEC), TRIAS 99-017-02, Electric Motor Maximum Output and Rated Output Test, [searched on September 23, 2024], the Internet (URL: https://www.naltec.go.jp/publication/regulation/fkoifn0 0000001jx-att/fkoifn0000000ysy.pdf)

In practice, there are cases where regulatory restrictions are imposed to limit the rated output of electric motors to or below a predetermined output. Specific examples may include where the foregoing small electric mobility devices are registered in a predetermined vehicle category. For example, to register an electric mobility device in the category of specified small motorized bicycles, the rated output of the electric motor needs to be limited to or below 600 W.

Since the rated output is a value that can be freely determined by the motor manufacturer or the like, there is a possibility that even vehicles equipped with electric motors having excessive margin relative to the rated output required by regulations as described above can be registered in a predetermined category (for example, the category of specified small motorized bicycles). In such a case, the original goal of the regulations "to exclude registration of vehicles equipped with electric motors having performance substantially exceeding their rated output" may fail.

As described above, the rated output is originally an index indicating whether an electric motor has an output capability above a certain level. In the interest of reducing manufacturing costs of electric motors, manufactures and the like are unlikely to deliberately manufacture electric motors having output characteristics with excessive margin relative to the rated output specified for the vehicles on which the motors are mounted, and are rather presumed to be motivated to minimize the output margin as much as possible. Conventionally, the need to evaluate the output margin of electric motors therefore has not been high, and no test method for evaluating output margin has been established despite the presence of tests such as those described in Non-Patent Literature 1.

### Summary of Invention

The present invention has been achieved in view of the foregoing problems, and provides a motor evaluation index presentation apparatus, a motor output evaluation system, and a motor evaluation index presentation method that can evaluate the output margin of a motor using a simple structure and technique.

A motor evaluation index presentation apparatus according to an aspect of the present invention is a motor evaluation index presentation apparatus for presenting an evaluation index for evaluating an output (hereinafter, evaluation target output) of an electric motor mounted on a vehicle. The motor evaluation index presentation apparatus includes: an output measurement device configured to measure the output of the electric motor or output of the vehicle on which the electric motor is mounted, and/or a temperature measurement device configured to measure surface temperature of the electric motor; and a margin data generator configured to generate and output margin determination data for determining the magnitude of the margin relative to the evaluation target output of the electric motor. The margin data generator is configured to, after the electric motor is driven in an output range including the evaluation target output for a predetermined time (hereinafter, test time), generate data on the amount of drop in the output of the electric motor or the output of the vehicle on which the electric motor is mounted as the margin determination data if the output measurement device is included, and generate data on the surface temperature of the electric motor as the margin determination data if the temperature measurement device is included.

A motor output evaluation system according to a first aspect of the present invention is a motor output evaluation system for evaluating an output (hereinafter, evaluation target output) of an electric motor mounted on a vehicle, the motor output evaluation system including the foregoing motor evaluation index presentation apparatus, and a margin determination apparatus configured to determine the magnitude of the margin. The motor evaluation index presentation apparatus includes the output measurement device. The margin determination apparatus includes: a margin determination data acquisition unit configured to acquire the margin determination data; and a determination unit configured to refer to the margin determination data, and if the amount of drop in the output of the electric motor or the vehicle on which the electric motor is mounted is less than a predetermined threshold (hereinafter, output threshold), determine that the margin is large, and if the amount of drop in the output of the electric motor or the vehicle on which the electric motor is mounted is greater than or equal to the output threshold, determine that the margin is small.

A motor output evaluation system according to a second aspect of the present invention is a motor output evaluation system for evaluating an output (hereinafter, evaluation target output) of an electric motor mounted on a vehicle, the motor output evaluation system including the foregoing motor evaluation index presentation apparatus and a margin determination apparatus configured to determine magnitude of the margin. The motor evaluation index presentation apparatus includes the temperature measurement device. The margin determination apparatus includes: a margin determination data acquisition unit configured to acquire the margin determination data; and a determination unit configured to refer to the margin determination data, and if a value of the surface temperature of the electric motor is less than a predetermined threshold (hereinafter, temperature threshold), determine that the margin is large, and if the value of the surface temperature of the electric motor is greater than or equal to the temperature threshold, determine that the margin is small.

According to a third aspect of the present invention, in the motor output evaluation system in the first aspect, the margin determination apparatus may further include a stop instruction unit configured to, if the amount of drop in the output of the electric motor or the vehicle on which the electric motor is mounted reaches or exceeds the output threshold before a lapse of the test time, determine that the margin is small, and issue an instruction to stop driving the electric motor.

According to a fourth aspect of the present invention, in the motor output evaluation system in the second aspect, the margin determination apparatus may further include a stop instruction unit configured to, if the value of the surface temperature of the electric motor reaches or exceeds the temperature threshold before a lapse of the test time, determine that the margin is small, and issue an instruction to stop driving the electric motor.

According to a fifth aspect of the present invention, the motor output evaluation system in the first aspect may further include a running test apparatus configured to run the vehicle. The output measurement device may be configured to measure the output of the vehicle. The margin determination data may be data on the amount of drop in the output of the vehicle when a running test where the vehicle is run at a speed to exhibit the evaluation target output (hereinafter, evaluation output corresponding speed) for the test time is performed using the running test apparatus.

According to a sixth aspect of the present invention, the motor output evaluation system in the second aspect may further include a running test apparatus configured to run the vehicle. The margin determination data may be data on the surface temperature of the electric motor when a running test where the vehicle is run at a speed to exhibit the evaluation target output (hereinafter, evaluation output corresponding speed) for the test time is performed using the running test apparatus.

According to a seventh aspect of the present invention, in the motor output evaluation systems in the fifth or the sixth aspect, the running test may include running the vehicle at a first speed and a second speed, the first speed being a lower one of the evaluation output corresponding speed, the second speed being a higher one of the evaluation output corresponding speed.

According to an eighth aspect of the present invention, in the motor output evaluation system in the seventh aspect, the running test may include a first test stage where the vehicle continues to be run at the second speed for a predetermined time, a second test stage where the vehicle continues to be run at the first speed for a predetermined time and then continues to be run at the second speed for a predetermined time, and a third test stage where the vehicle continues to be run at the first speed for a predetermined time.

According to a ninth aspect of the present invention, in the motor output evaluation system in the eighth aspect, the second test stage may include a plurality of stages where a running time of the vehicle at the first speed increases gradually.

According to a tenth aspect of the present invention, in the motor output evaluation systems in the fifth or the sixth aspect, the running test may alternate a test at the evaluation output corresponding speed and a test at a third speed lower than the evaluation output corresponding speed.

According to an eleventh aspect of the present invention, in the motor output evaluation system in the tenth aspect, the evaluation output corresponding speed in the running test may include a lower first speed and a higher second speed, and the third speed may be a speed between the first speed and the second speed.

According to a twelfth aspect of the present invention, in the motor output evaluation system in the eleventh aspect, the running test may include performing the test at the third speed a plurality of times, with the third speed reduced each time.

According to a thirteenth aspect of the present invention, the motor output evaluation systems in the fifth or the sixth aspect may further include a speed calculation apparatus configured to calculate the evaluation output corresponding speed to be used in the running test. The speed calculation apparatus may include: a vehicle speed-number of rotations characteristic input unit configured to input a vehicle speed-number of rotations characteristic indicating a relationship between a running speed of the vehicle and a number of rotations of the electric motor, the relationship being obtained by running the vehicle using the running test apparatus; a motor output-number of rotations input unit configured to input a motor output-number of rotations characteristic indicating a relationship acquired in advance between the output of the electric motor and the number of rotations of the electric motor; a motor output-vehicle speed characteristic generation unit configured to generate a motor output-vehicle speed characteristic indicating a relationship between the output of the electric motor and the running speed of the vehicle from the vehicle speed-number of rotations characteristic and the motor output-number of rotations characteristic; and a speed calculation unit configured to calculate the evaluation output corresponding speed from the motor output-vehicle speed characteristic.

According to a fourteenth aspect of the present invention, the motor output evaluation systems in the fifth or the sixth aspect may further include a speed calculation apparatus configured to calculate the evaluation output corresponding speed to be used in the running test. The speed calculation apparatus may include: a vehicle output-vehicle speed characteristic input unit configured to input a vehicle output-vehicle speed characteristic indicating a relationship between the output of the vehicle and a running speed of the vehicle, the relationship being obtained by running the vehicle using the running test apparatus; a loss correction unit configured to calculate a motor output-vehicle speed characteristic by correcting the vehicle output-vehicle speed characteristic based on a driving loss component of the vehicle; and a speed calculation unit configured to calculate the evaluation output corresponding speed from the motor output-vehicle speed characteristic.

According to a fifteenth aspect of the present invention, in the motor output evaluation systems in the fifth or the sixth aspect, the margin determination apparatus may further include a test nonexecution instruction unit configured to refer to a motor output-vehicle speed characteristic indicating a relationship between the output of the electric motor and the running speed of the vehicle, and if a maximum output of the electric motor is less than or equal to the evaluation target output, determine that the margin is small, and issue an instruction to not execute the running test.

A motor evaluation index presentation method according to an aspect of the present invention is a motor evaluation index presentation method for presenting an evaluation index for evaluating an output (hereinafter, evaluation target output) of an electric motor mounted on a vehicle. The motor evaluation index presentation method includes: an output measurement step of measuring the output of the electric motor or output of the vehicle on which the electric motor is mounted, and/or a temperature measurement step of measuring surface temperature of the electric motor; and a margin data generation step of generating and outputting margin determination data for determining magnitude of margin relative to the evaluation target output of the electric motor. In the margin data generation step after the electric motor is driven in an output range including the evaluation target output for a predetermined time (hereinafter, test time), data on an amount of drop in the output of the electric motor or the output of the vehicle on which the electric motor is mounted is generated as the margin determination data if the output measurement step is included, and data on the surface temperature of the electric motor is generated as the margin determination data if the temperature measurement step is included.

The foregoing motor evaluation index presentation apparatus, motor output evaluation system, and motor evaluation index presentation method enable evaluation of the output margin of an electric motor using a simple structure and technique.

### Brief Description of Drawings

Fig. 1 is a side view showing an overall configuration of a motor output evaluation system according to an embodiment of the present invention.
Fig. 2 is a functional block diagram of a margin determination apparatus in the evaluation system.
Fig. 3 is a graph showing a relationship between the running speed of a vehicle and the output of the vehicle (or motor alone).
Fig. 4 is a functional block diagram of a speed calculation apparatus in the evaluation system.
Fig. 5 is a flowchart showing a motor output evaluation method using the evaluation system.
Fig. 6 is a graph showing the results of motor output evaluation for describing the effect of the evaluation system.
Fig. 7 is a diagram showing the conditions and test procedure of a running test according to a first modification of the evaluation system.
Fig. 8 is a diagram showing the conditions and test procedure of a running test according to a first example of a second modification of the evaluation system.
Fig. 9 is a graph assuming the results of the running test according to the first example of the second modification of the evaluation system.
Fig. 10 is a diagram showing the conditions and test procedure of a running test according to a second example of the second modification of the evaluation system.
Fig. 11 is a functional block diagram of a speed calculation apparatus according to a third modification of the evaluation system.
Fig. 12 is a diagram schematically showing only essential parts in a second preliminary running test performed in the third modification of the evaluation system.
Fig. 13 is a flowchart showing a motor output evaluation method using the third modification of the evaluation system.

### Description of Embodiments

A motor output evaluation system 100 according to a first embodiment of the present invention will be described below with reference to the accompanying drawings. In the present disclosure, the terms "electric motor" and "motor" are used interchangeably, and both refer to an electric motor.

### <Overall Configuration>

The motor output evaluation system (hereinafter, evaluation system) 100 is an apparatus for evaluating the output of an electric motor (or simply "motor") 210 mounted on a vehicle 200. As employed herein, the vehicle 200 is assumed to be a small electric mobility device such as an electric kick scooter, but is not limited thereto in particular. For example, in the present embodiment, the output of the motor 210 to be evaluated by the evaluation system 100 (evaluation target output) is a "rated output" nominally stated by the manufacturer or the like of the motor 210. However, the evaluation target output of the motor 210 is not limited in particular and can be set as various outputs.

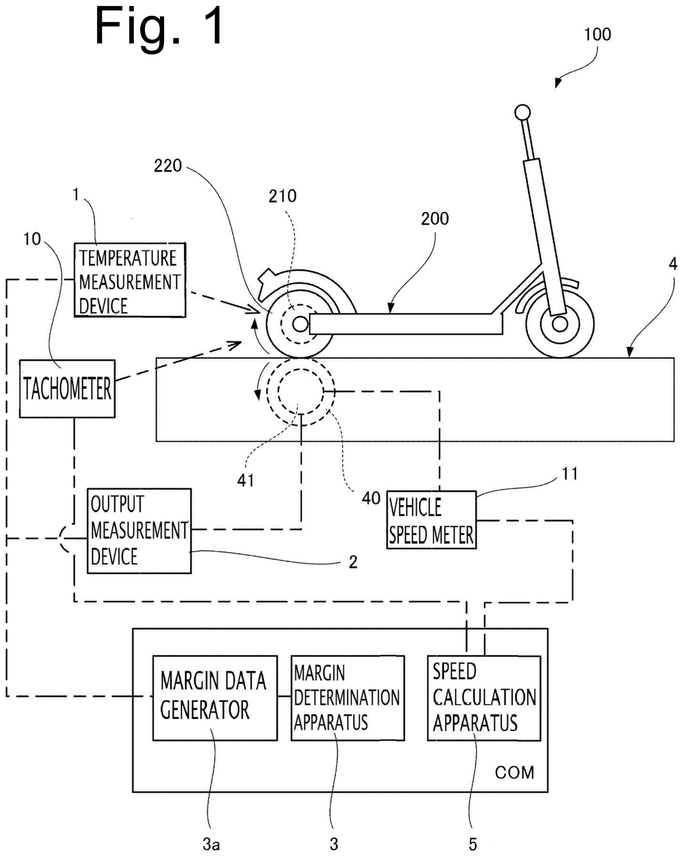

As shown in Fig. 1, the evaluation system 100 includes a temperature measurement device 1, an output measurement device 2, a margin determination apparatus 3, a running test apparatus 4, and a speed calculation apparatus 5. The temperature measurement device 1 is configured to measure a surface temperature Ts of the motor 210 as mounted on the vehicle 200. The output measurement device 2 is configured to measure an output Pc of the vehicle 200. The margin determination apparatus 3 is electrically connected to the temperature measurement device 1 and the output measurement device 2. The running test apparatus 4 is configured to run the vehicle 200 on which the motor 210 is mounted. The speed calculation apparatus 5 is configured to calculate data needed in performing a running test that uses the running test apparatus 4.

The temperature measurement device 1, for example, includes a thermographic camera, and is positioned facing the motor 210 so as to be capable of continuously measuring the surface temperature Ts of the motor 210. In the present embodiment, the temperature measurement device 1 is configured to identify the spot exhibiting the highest temperature (maximum heat generation spot) on the surface of the motor 210 while the vehicle 200 is running, and continuously measure the spot for temperature changes.

The output measurement device 2 is disposed on the running test apparatus 4 to be described in detail below, and is configured to continuously measure the output Pc of the vehicle 200.

The running test apparatus 4 is a chassis dynamometer or the like, for example. The running test apparatus 4 includes a roller 40 that makes contact with a tire 220 of the vehicle 200 equipped with the motor 210, and a measurement electric motor 41 functioning as a dynamo (load adjustor) connected to the roller 40. The running test apparatus 4 is configured to apply to the tire 220 a load similar to that which acts on the tire 220 during actual running of the vehicle 200. As described above, the test running apparatus 4 includes the output measurement device 2, which is configured to measure the output of the vehicle 200 from the load acting on the tire 220 on the running test apparatus 4 (this load refers to that such as the regenerative output of the measurement electric motor 41).

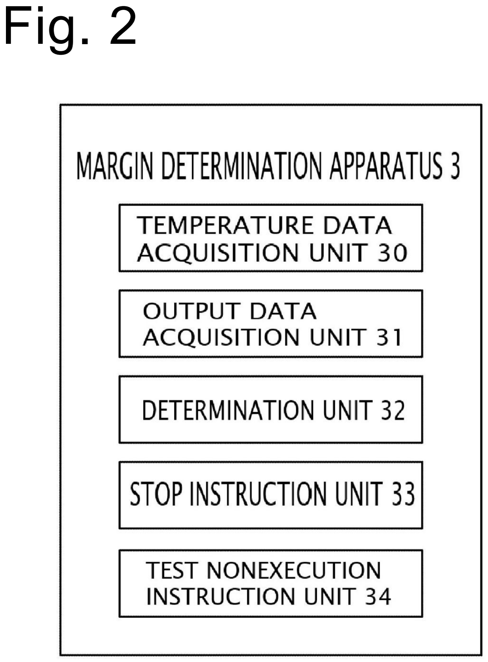

In a running test in which the vehicle 200 is run for a predetermined time (hereinafter referred to as a test time t), the margin determination apparatus 3 determines the magnitude of the margin relative to a rated output Pr of the motor 210 when the motor 210 is driven for the test time t. The margin determination apparatus 3 is implemented by a computer COM including a processor and the like. The margin determination apparatus 3 includes a margin data generator 3a that is also implemented by the computer COM. The margin data generator 3a generates data on the amount of drop in the output Pc of the vehicle 200 after the motor 210 is driven in an output range including the rated output Pr for the test time t, i.e., after a running test in which the vehicle 200 is run at a speed to exhibit the rated output Pr for the test time t using the running test apparatus 4, as margin measurement data. As shown in Fig. 2, the margin determination apparatus 3 includes a temperature data acquisition unit 30, an output data acquisition unit (margin determination data acquisition unit) 31, a determination unit 32, a stop instruction unit 33, and a test nonexecution instruction unit 34. The temperature data acquisition unit 30 is configured to acquire data on the surface temperature Ts of the motor 210. The output data acquisition unit 31 is configured to acquire data on the amount of drop in the output Pc of the vehicle 200 (margin determination data). The determination unit 32 is configured to refer to the data on the amount of drop in the output Pc of the vehicle 200 and determine the margin relative to the rated output Pr of the motor 210. The stop instruction unit 33 is configured to issue instructions to stop driving the motor 210 under a predetermined condition, which will be described below, before a lapse of the test time t. The test nonexecution instruction unit 34 is configured to issue instructions to not execute the running test under a predetermined condition, which will be described below, before the running test is started.

The temperature data acquisition unit 30 is configured to continuously acquire the data on the surface temperature Ts of the motor 210 measured by the temperature measurement device 1.
The output data acquisition unit 31 is configured to continuously acquire the data on the output Pc of the vehicle 200 measured by the output measurement device 2, and also acquire the margin determination data that is the data on the amount of drop in the output Pc.

The determination unit 32 is configured to determine the margin relative to the rated output Pr of the motor 210 based on the amount of drop in the output Pc of the vehicle 200 acquired from the margin data generator 3a.

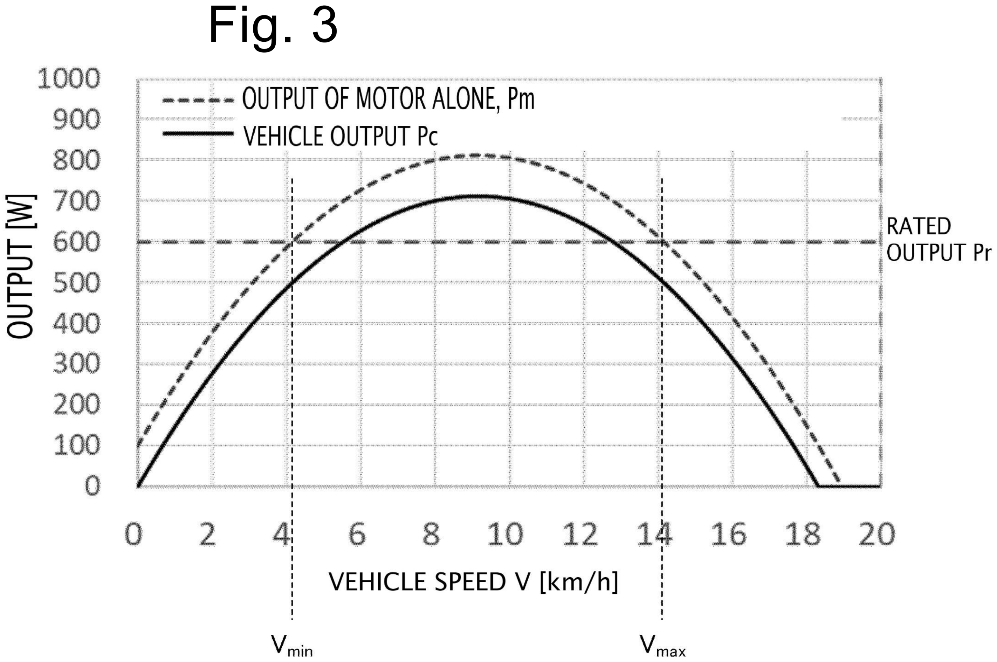

As shown in Fig. 3, running speed V of the vehicle 200 and the output Pc of the vehicle 200 (or output Pm of the motor 210 alone) typically have a relationship such that the output increases gradually from the low-speed region, reaches the maximum output, and then drops again in the high-speed region. For example, with the foregoing rated output Pr as 600 W, there can be two speeds of the vehicle 200 at which this rated output Pr is exhibited, i.e., evaluation output corresponding speeds that are a lower first speed Vₘᵢₙ and a higher second speed Vₘₐₓ. In the present embodiment, the first speed Vₘᵢₙ and the second speed Vₘₐₓ are calculated by the speed calculation apparatus 5 to be described below.

The rated output Pr of the motor 210 is the same as the upper limit value of the output of the motor 210 required by the regulations. For example, if the vehicle 200 is a specified small motorized bicycle, the rated output Pr is 600 [W]. Since the vehicle 200 includes a power transmission mechanism and a control device (electronic control unit [ECU]), there is a difference between the output Pc of the vehicle 200 and the output Pm of the motor 210 alone as shown in Fig. 3. The output Pc of the vehicle 200 and the output Pm of the motor 210 thus do not necessarily match. In the present embodiment, the speed calculation apparatus 5 to be described in detail below is provided because the first speed Vₘᵢₙ and the second speed Vₘₐₓ are unable to be directly calculated from the output Pc of the vehicle 200 measured by the output measurement device 2.

If the amount of drop in the output Pc of the vehicle 200 is less than a predetermined threshold (hereinafter, output threshold Pth), the determination unit 32 determines that the margin relative to the rated output Pr is large. If the amount of drop in the output Pc of the vehicle 200 is greater than or equal to the output threshold Pth, the determination unit 32 determines that the margin is small. Specifically, if, for example, the amount of drop in the output Pc of the vehicle 200 at the end of the running test, compared to the start, is less than 4%, the margin relative to the rated output Pr is determined to be large. If the amount of drop in the output Pc is 4% or more, the margin relative to the rated output Pr is determined to be small.

The stop instruction unit 33 is configured to issue instructions to stop driving the motor 210, i.e., terminate the running test of the vehicle 200 if the amount of drop in the output Pc of the vehicle 200 reaches or exceeds the output threshold Pth, or if the value of the surface temperature Ts of the motor 210 reaches or exceeds a predetermined threshold (hereinafter, temperature threshold Tth), before the test time t expires. In such cases, the margin relative to the rated output Pr of the motor 210 is determined to be small.

The test nonexecution instruction unit 34 is configured to refer to a motor output-vehicle speed characteristic indicating the relationship between the output Pm of the motor 210 and the running speed V of the vehicle 200. If the maximum output of the motor 210 is less than or equal to the rated output Pr, the test nonexecution instruction unit 34 determines that the margin relative to the rated output Pr is small, and issues instructions to not execute a running test. The motor output-vehicle speed characteristic for the test nonexecution instruction unit 34 to refer to is generated by the speed calculation apparatus 5 described below.

The speed calculation apparatus 5 is implemented by, for example, the foregoing computer COM constituting the margin determination apparatus 3 (see Fig. 1), and is configured to calculate the data to be used in the running test in which the vehicle 200 is run using the running test apparatus 4. Specifically, the speed calculation apparatus 5 calculates the first speed Vₘᵢₙ and the second speed Vₘₐₓ that are the evaluation output corresponding speeds of the vehicle 200 for exhibiting the rated output Pr of the motor 210.

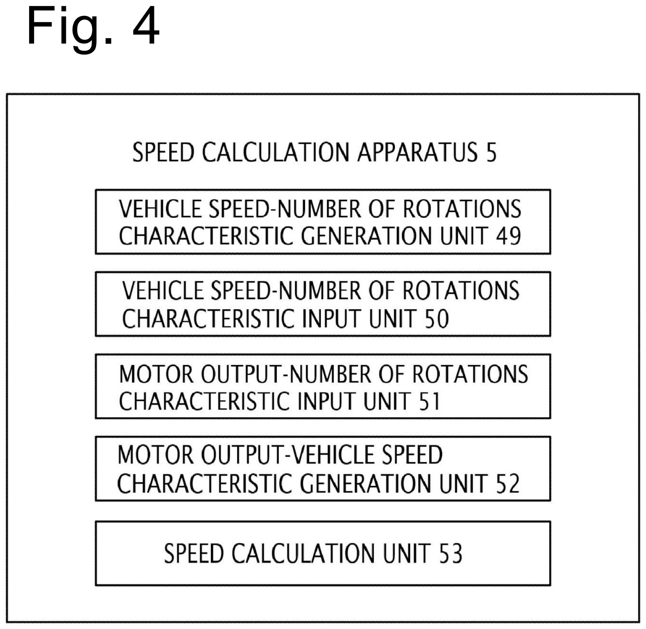

Specifically, as shown in Fig. 4, the speed calculation apparatus 5 includes a vehicle speed-number of rotations characteristic generation unit 49, a vehicle speed-number of rotations characteristic input unit 50, a motor output-number of rotations characteristic input unit 51, a motor output-vehicle speed characteristic generation unit 52, and a speed calculation unit 53.

The vehicle speed-number of rotations characteristic generation unit 49 is configured to generate a vehicle speed-number of rotations characteristic that indicates the relationship between the running speed V of the vehicle 200 and the number of rotations of the motor 210 corresponding to the running speed V, which is obtained by running the vehicle 200 using the running test apparatus 4. More specifically, the speed calculation apparatus 5 is electrically connected to a tachometer 10 and a vehicle speed meter 11 disposed on the running test apparatus 4 (see Fig. 1). The vehicle speed-number of rotations characteristic generation unit 49 is configured to acquire measurement data from the tachometer 10 and the vehicle speed meter 11, and generate the vehicle speed-number of rotations characteristic. For example, an optical non-contact tachometer using laser light or the like is suitably used as the tachometer 10. In generating the vehicle speed-number of rotations characteristic, a preliminary running test is performed, using the running test apparatus 4, solely for the purpose of generating the vehicle speed-number of rotations characteristic. If the vehicle speed-number of rotations characteristic is available in advance, the vehicle speed-number of rotations characteristic generation unit 49 may be omitted.

The vehicle speed-number of rotations characteristic input unit 50 inputs the foregoing vehicle speed-number of rotations characteristic. If the vehicle speed-number of rotations characteristic is available in advance, the vehicle speed-number of rotations characteristic may be manually input by the person who conducts the running test.

The motor output-number of rotations characteristic input unit 51 inputs a motor output-number of rotations characteristic indicating the relationship between the output of the motor 210 and the number of rotations of the motor 210, which is acquired from the manufacturer or the like of the motor 210 in advance. For example, the motor output-number of rotations characteristic is manually input by the person who conducts the running test.

The motor output-vehicle speed characteristic generation unit 52 is configured to generate a motor output-vehicle speed characteristic indicating the relationship between the output of the motor 210 and the running speed V of the vehicle 200 from the input vehicle speed-number of rotations characteristic and motor output-number of rotations characteristic.

The speed calculation unit 53 is configured to calculate the first speed Vₘᵢₙ and the second speed Vₘₐₓ serving as the evaluation output corresponding speeds from the motor output-vehicle speed characteristic generated by the motor output-vehicle speed characteristic generation unit 52.

### <Procedure for Determining Magnitude of Margin Relative to Rated Output>

Next, a procedure for determining the magnitude of margin of the motor 210 relative to the rated output Pr, i.e., an output evaluation method of the motor 210 will be described.

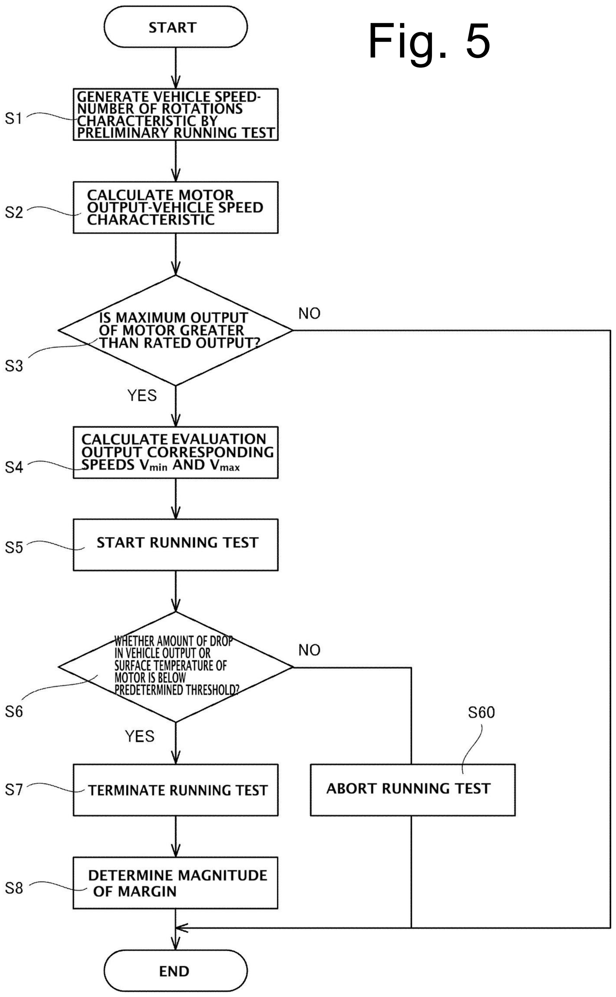

As shown in Fig. 5, the preliminary running test of the vehicle 200 is initially performed using the running test apparatus 4 to generate the vehicle speed-number of rotations characteristic indicating the relationship between the running speed V of the vehicle 200 and the number of rotations of the motor 210 (step S1).

Conditions for the preliminary running test include the following: the running test apparatus 4 and the vehicle 200 are installed in a test environment with a room temperature of 22°C and no wind, and the motor 210 is powered by a direct-current stabilized power supply capable of supplying constant-voltage power, not by a battery (not shown) mounted on the vehicle 200. Here, the vehicle 200 may be retrofitted to add terminals to which the direct-current stabilized power supply can be connected. In the preliminary running test, the vehicle 200 is initially warmed up as a preparatory test. This preparatory test is terminated when the surface temperature Ts of the motor 210 reaches 40°C. The motor 210 is then cooled to a surface temperature Ts of 30°C, and the main test of the preliminary running test is then performed to generate the vehicle speed-number of rotations characteristic.

As described above, the motor output-vehicle speed characteristic is then calculated from the vehicle speed-number of rotations characteristic (step S2). Whether the motor 210 has an output higher than the rated output Pr, i.e., whether the maximum output of the motor 210 is greater than the rated output Pr is then determined from the motor output-vehicle speed characteristic (step S3). If, in step S3, the motor 210 has an output higher than the rated output Pr, the determination is "YES" and the processing proceeds to step S4. On the other hand, if, in step S3, the motor 210 does not have an output higher than the rated output Pr (the maximum output of the motor 210 is less than or equal to the rated output Pr), the determination is "NO". The margin relative to the rated output Pr is determined to be small, and the procedure ends without performing a running test.

In step S4, the evaluation output corresponding speeds corresponding to the rated output Pr, i.e., the first speed Vₘᵢₙ and the second speed Vₘₐₓ are calculated. A running test with the first speed Vₘᵢₙ is then started (step S5). In the running test of the present embodiment, the vehicle 200 is run at the first speed Vₘᵢₙ for one hour, for example. The running test apparatus 4 inputs test condition data such as the test time t and the first speed Vₘᵢₙ to a not-shown control apparatus, and performs a running test. In the running test, the motor 210 is powered by the direct-current stabilized power supply and run at full throttle in the same environment as in the foregoing preliminary running test.

After the start of the running test in step S5, whether the amount of drop in the output Pc of the vehicle 200 is less than the output threshold Pth or whether the value of the surface temperature Ts of the motor 210 is less than the temperature threshold Tth is determined before the expiration of the predetermined test time t (step S6). If, in step S6, the amount of drop in the output of the vehicle 200 is less than the output threshold Pth or the value of the surface temperature of the motor 210 is less than the predetermined temperature threshold Tth, the determination is "YES" and the running test is continued. After a lapse of the test time t from the start of the running test, the running test is terminated (step S7).

After the test time t has elapsed from the start of the running test and the running test is then terminated in step S7, whether the amount of drop in the output Pc of the vehicle 200 is less than the output threshold Pth is determined (step S8). If, in step S8, the amount of drop in the output Pc of the vehicle 200 is less than the output threshold Pth, the margin relative to the rated output Pr of the motor 210 is determined to be large, and the procedure ends. On the other hand, if, in step S8, the amount of drop in the output Pc of the vehicle 200 is greater than or equal to the output threshold Pth, the margin relative to the rated output Pr of the motor 210 is determined to be small, and the procedure ends.

Return to step S6. If the amount of drop in the output Pc of the vehicle 200 is not less than the output threshold Pth (is greater than or equal to the output threshold Pth), or the value of the surface temperature Ts of the motor 210 is not less than the temperature threshold Tth (is greater than or equal to the temperature threshold Tth), the determination is "NO" and the processing proceeds to step S60. In step S60, the margin relative to the rated output Pr of the motor 210 is determined to be small, and instructions are issued to abort the running test, i.e., stop driving the motor 210 before a lapse of the test time t. The procedure then ends.

In the present embodiment, the output threshold Pth for the amount of drop in the output Pc is not limited to 4% described above, and may be changed as appropriate. The temperature threshold Tth is set to an allowable temperature (for example, temperature corresponding to the heat resistance class) of electrically insulated portions (such as winding portions) of the motor 210, for example, but is not limited in particular, either. In setting the temperature threshold Tth, the manufacturers of the motor 210 and the vehicle 200 may be requested to submit the following materials and the like: materials describing the heat resistance class of the motor 210 and the allowable temperature of the electrically insulated portions of the motor 210; materials describing the spot on the surface of the motor 210 where temperature can be measured during continuous operation of the motor 210 and that exhibits the maximum heat generation; materials describing the temperature of the maximum heat generation spot on the surface of the motor 210 when the temperature of the electrically insulated portions of the motor 210 exceeds the allowable temperature of the heat resistance class; and materials supporting the difference between the allowable temperature of the electrically insulated portions of the motor 210 and the allowable temperature of the maximum heat generation spot on the surface of the motor 210.

### <Operation and Effects>

The evaluation system 100 according to the present embodiment described above drives the motor 210 for a predetermined time (test time t) by running the vehicle 200 for the predetermined time (test time t) so that the motor 210 is driven in the output range including the rated output Pr. Then, if the amount of drop in the output Pc of the vehicle 200 is less than the predetermined output threshold Pth, the margin determination apparatus 3 determines that the margin relative to the rated output Pr of the motor 210 is large. If the amount of drop in the output Pc of the vehicle 200 is greater than or equal to the output threshold Pth, the margin determination apparatus 3 determines that the margin is small.

The amount of drop in the output Pc of the vehicle 200 will now be described in terms of real-world space. Suppose that the vehicle 200 is driven at full throttle to climb an uphill slope at the rated output and constant speed. To maintain the same speed as that at the beginning of travel, the gradient of the uphill slope needs to be reduced over time. The "reduction in the gradient of the uphill slope" is equivalent to a "drop in the output Pc", in which case the margin relative to the rated output can be said to be small. By contrast, if the "gradient of the uphill slope does not need to be reduced", it means that the "output Pc does not drop", or equivalently, the margin relative to the rated output is large.

In such a manner, the output of the motor 210 can be evaluated through the use of the extremely simple structure and technique of determining the margin relative to the rated output Pr based on the amount of drop in the output Pc of the vehicle 200. This enables the exclusion of registration of vehicles 200 equipped with motors 210 that have performance substantially exceeding the rated output Pr required by the regulations.

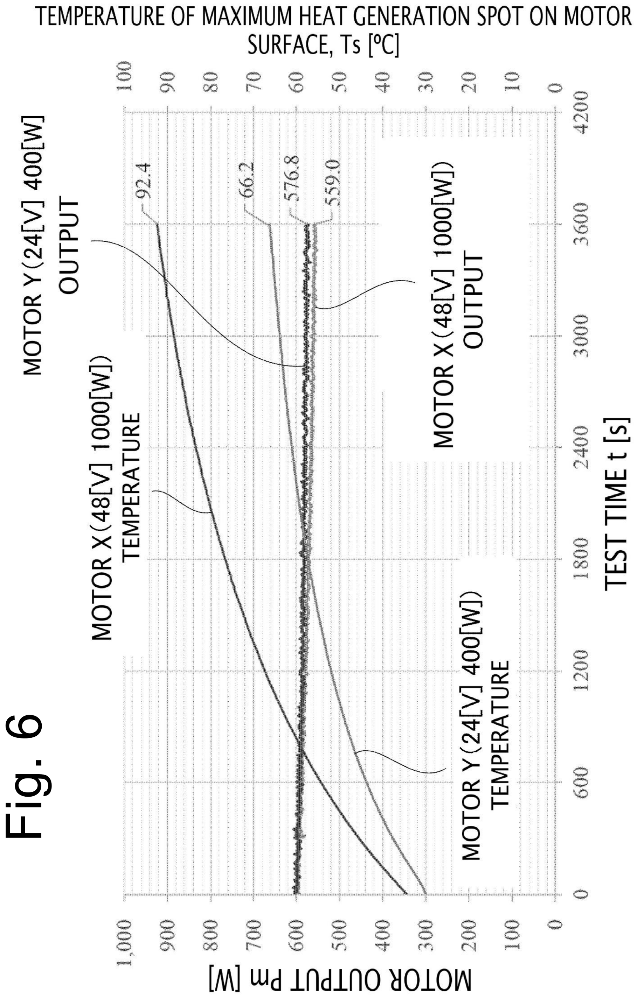

Fig. 6 is a graph showing changes in the output Pm of two different motors over time, observed by actually conducting a test of continuously driving the motors for one hour with the number of rotations at which 600 [W] is produced in a pre-test initial state. The two motors included a motor X with a nominal rated output Pr of 1000 [W] and a rated voltage of 48 [V], and a motor Y with a nominal rated output Pr of 400 [W] and a rated voltage of 24 [V]. In the test of Fig. 6, the evaluation target outputs of the motors were set not to their rated outputs but to 600 [W], and the margins of the motors X and Y with the different rated outputs were evaluated. Fig. 6 shows the results. The amount of drop in the output Pm of the motor X with the nominal rated output Pr of 1000 [W] is greater than that of the motor Y with the nominal rated output Pr of 400 [W]. The motor surface temperature Ts of the motor X is also higher. This implies that the motor Y with the nominal rated output Pr of 400 [W] has a margin greater than that of the motor X with the nominal rated output Pr of 1000 [W]. That is, the motor Y with the nominal rated output Pr of 400 [W] can apply to a "motor having performance substantially exceeding the rated output". The use of the evaluation system 100 according to the present embodiment can prevent the occurrence of such situations.

In the present embodiment, the margin relative to the rated output Pr of the motor 210 is evaluated by running the vehicle 200 using the running test apparatus 4. This eliminates the need to disassemble the vehicle 200 to take out the motor 210 and evaluate the margin of the motor 210 alone, and can reduce the effort needed for margin evaluation.

The margin determination apparatus 3 includes the stop instruction unit 33. The margin determination apparatus 3 thereby determines that the margin is small, and issues instructions to stop driving the motor 210 if the amount of drop in the output Pc of the vehicle 200 is greater than or equal to the predetermined output threshold Pth or if the value of the surface temperature Ts of the motor 210 is greater than or equal to the predetermined temperature threshold Tth. This can prevent situations where the motor 210 is overloaded and burns out during the running test.

Moreover, the inclusion of the test nonexecution instruction unit 34 in the margin determination apparatus 3 precludes needless running tests.

### (First Modification)

Next, a first modification of the foregoing embodiment will be described. The evaluation system 100 of the first modification runs the vehicle 200 at the first speed Vₘᵢₙ and the second speed Vₘₐₓ that are the evaluation output corresponding speeds of the vehicle 200 as a running test for margin evaluation.

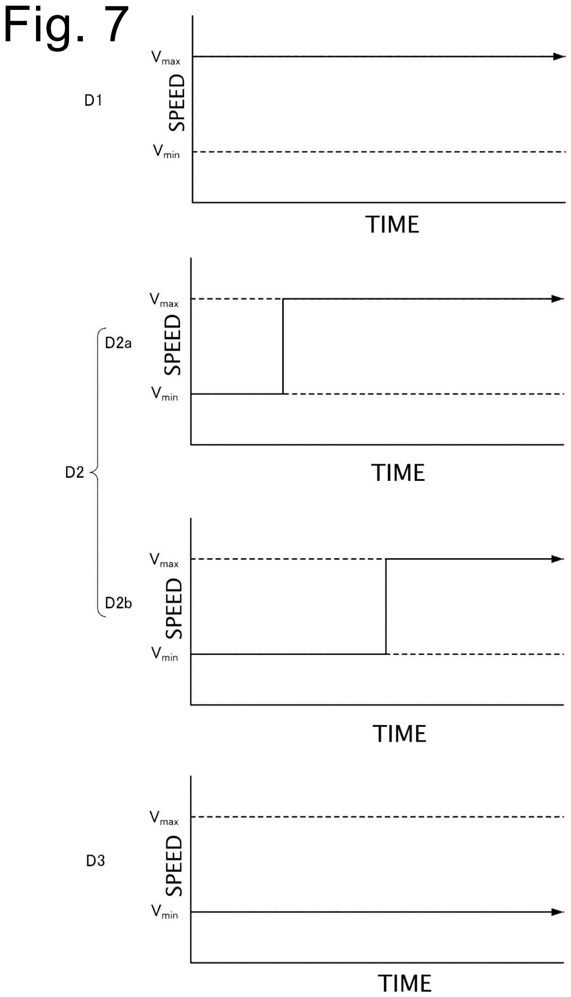

Specifically, as shown in Fig. 7, a first test stage D1, a second test stage D2, and a third test stage D3 with respective different conditions are conducted as a running test during the foregoing test time t.

In the first test stage D1, the vehicle 200 continues to be run at the second speed Vₘₐₓ for a predetermined time. In the second test stage D2, the vehicle 200 continues to be run at the first speed Vₘᵢₙ for a predetermined time, and then continues to be run at the second speed Vₘₐₓ for a predetermined time. In the third test stage D3, the vehicle 200 continues to be run at the first speed Vₘᵢₙ for a predetermined time. The second test stage D2 includes a plurality of stages where the running time at the second speed Vₘₐₓ decreases gradually and the running time at the first speed Vₘᵢₙ increases gradually. In the present embodiment, the second test stage D2 includes two stages, a first second-test stage D2a and a second second-test stage D2b. Examples of the conditions in the respective test stages are as follows:
- First Test Stage D1:
   Running time at the first speed Vₘᵢₙ: 0 [min]
   Running time at the second speed Vₘₐₓ: 5 [min]
- First Second-Test Stage D2a:
   Running time at the first speed Vₘᵢₙ: 1 [min]
   Running time at the second speed Vₘₐₓ: 4 [min]
- Second Second-Test Stage D2b:
   Running time at the first speed Vₘᵢₙ: 3 [min]
   Running time at the second speed Vₘₐₓ: 2 [min]
- Third Test Stage D3:
   Running time at the first speed Vₘᵢₙ: 5 [min]
   Running time at the second speed Vₘₐₓ: 0 [min]

Each of the foregoing first to third test stages D1 to D3 may be performed for a plurality of cycles (for example, 12 cycles). For example, when the first test stage D1 is performed for 12 cycles, the vehicle 200 continues to be run for 5 [min] × 12 = 1 [h]. Similarly, the test stages D2a, D2b, and D3 are each performed for 5 [min] × 12 = 1 [h]. The 12 cycles of each test stage are followed by a cooling time for the motor 210, whereby the motor 210 is cooled until its surface temperature Ts measured by the temperature measurement device 1 falls to or below approximately 30°C, before transition to the next test stage.

When the running test is performed in the foregoing cycles, the stop instruction unit 33 of the margin determination apparatus 3 may issue instructions to stop driving the motor 210 if the amount of drop in the output Pc of the vehicle 200 reaches or exceeds the output threshold Pth, or if the value of the surface temperature Ts of the motor 210 reaches or exceeds the temperature threshold Tth, before the motor 210 is cooled between the test stages.

Performing the running test in such cycles enables gradual transitions to severer load conditions, compared to when the running test is performed only at the first speed Vₘᵢₙ that is an extremely severe load condition. This can prevent situations where the motor 210 is overloaded and burns out during the running test.

### (Second Modification)

Next, a second modification of the foregoing embodiment will be described. The evaluation system 100 of the second modification runs the vehicle 200 at either of the first speed Vₘᵢₙ and the second speed Vₘₐₓ that are the evaluation output corresponding speeds of the vehicle 200, and at a third speed V_{load} lower than the first speed Vₘᵢₙ or the second speed Vₘₐₓ, as a running test for margin evaluation.

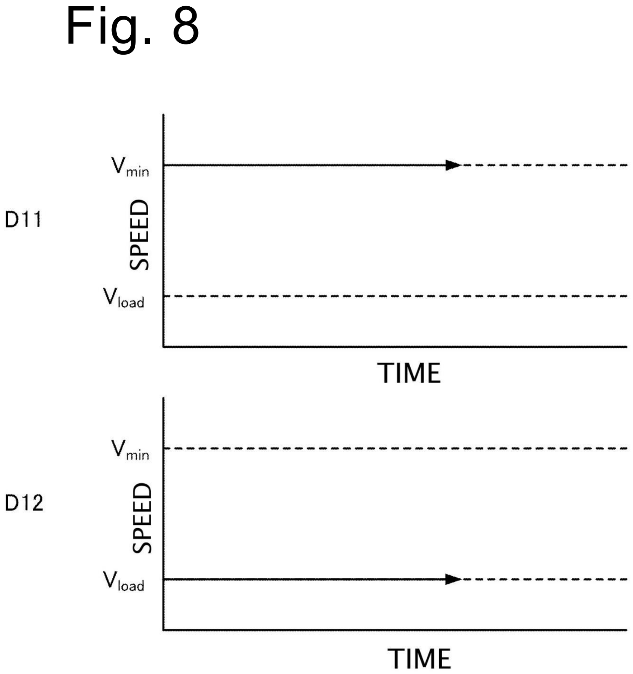

In a first example of the second modification, as shown in Fig. 8, a test stage D11 at the first speed Vₘᵢₙ and a test stage D12 at the third speed V_{load} lower than the first speed Vₘᵢₙ are alternately performed in the running test. Here, the output Pm of the motor 210 corresponding to the third speed V_{load} is lower than the rated output Pr that is the output of the motor 210 at the first speed Vₘᵢₙ (see Fig. 3). Meanwhile, the current value increases, which means a high load state to the motor 210. In other words, reducing the speed from the first speed Vₘᵢₙ to the third speed V_{load} is analogous to slowing down the vehicle 200 by gripping the rotating shaft of the motor 210. Another analogy is to temporarily increase the gradient of the uphill slope when the vehicle 200 climbs the uphill slope.

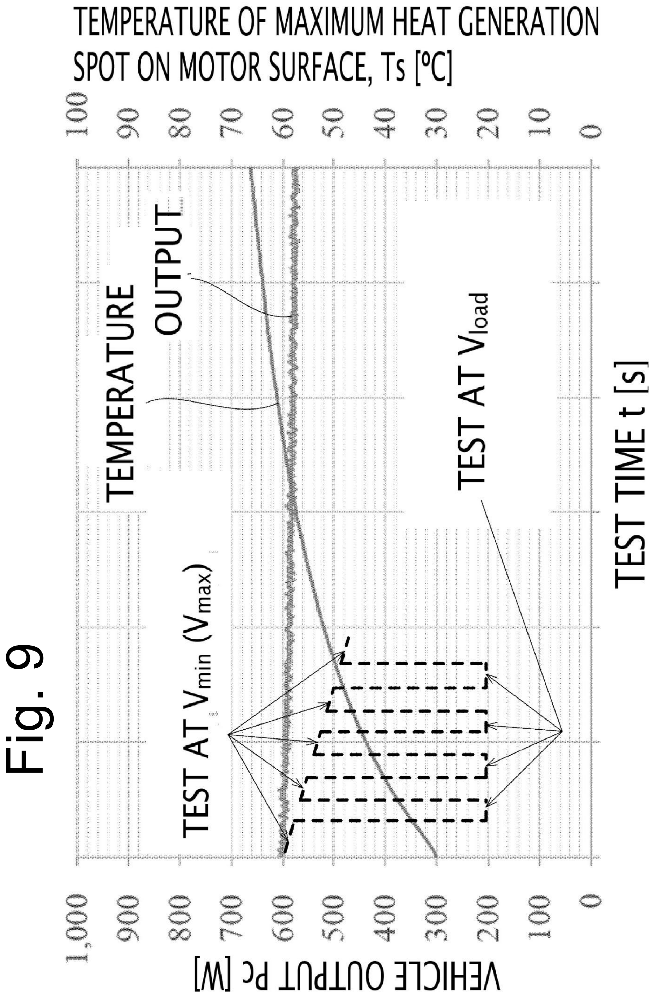

Incorporating such a test stage using the third speed V_{load} can reduce the total test time t until margin determination, compared to when the running test is simply performed at the first speed Vₘᵢₙ alone. Moreover, the addition of the test at the third speed V_{load} can make the motor 210 "fatigued" over time. When returning from the test at the third speed V_{load} to the test at the first speed Vₘᵢₙ, the motor 210 can start to be tested with its output Pm lower than in the previous test at the first speed Vₘᵢₙ. Specifically, as shown by the broken line in Fig. 9, the output Pc of the vehicle 200 at the first speed Vₘᵢₙ decreases each time the test speed returns from the third speed V_{load} to the first speed Vₘᵢₙ (the same applies to the second speed Vₘₐₓ). Since the next test at the third speed V_{load} starts with the base output Pm of the motor 210 reduced at the beginning of each stage, the motor 210 is loaded further and the test time t needed for the margin evaluation can be shortened.

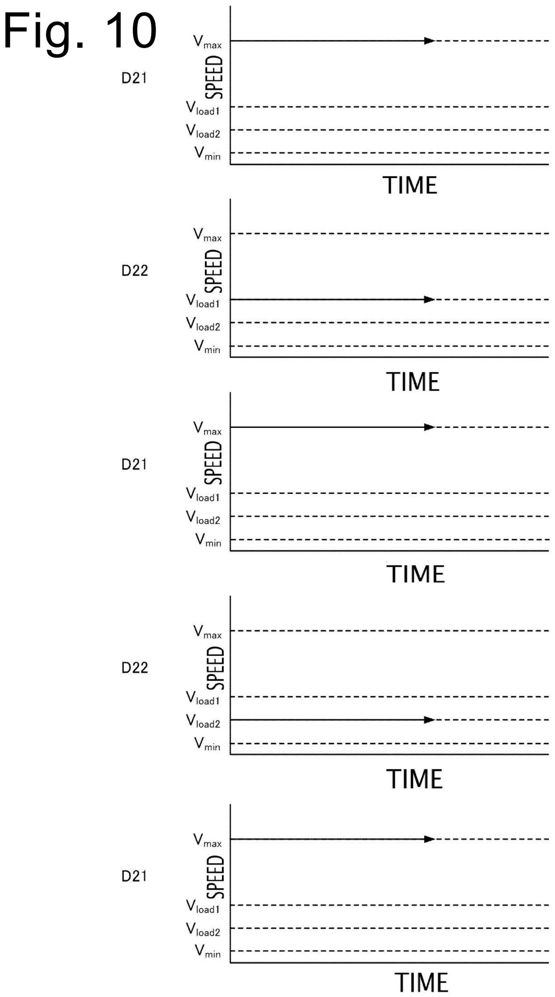

In a second example of the second modification, as shown in Fig. 10, a test stage D21 at the second speed Vₘₐₓ and a test stage D22 at a third speed V_{load} lower than the second speed Vₘₐₓ are alternately performed in the running test. The third speed V_{load} here is set to a speed between the first speed Vₘᵢₙ and the second speed Vₘₐₓ, or more specifically, higher than the first speed Vₘᵢₙ and lower than the second speed Vₘₐₓ. However, the third speed V_{load} may be lower than the first speed Vₘᵢₙ. In the case where the third speed V_{load} is set to a speed higher than the first speed Vₘᵢₙ and lower than the second speed Vₘₐₓ, the output Pm of the motor 210 at the third speed V_{load} exceeds the rated output Pr. This is suitable when evaluating the margin relative to a predetermined evaluation target output different from the rated output of the motor 210, rather than when evaluating the margin relative to the rated output.

The output Pm of the motor 210 corresponding to the third speed V_{load} is higher than the rated output Pr that is the output of the motor 210 at the second speed Vₘₐₓ (see Fig. 3), and the current value also becomes higher. This can reduce the total test time t until margin evaluation, compared to the case where the running test is simply performed at the second speed Vₘₐₓ alone. The inclusion of the test at the third speed V_{load} on the basis of the test at the second speed Vₘₐₓ where both the output Pm and current value of the motor 210 are low provides the advantage that the test time t can be reduced along with a reduction in the possibilities of burnout and other damages to the motor 210. When the test at the third speed V_{load} and the test at the second speed Vₘₐₓ are alternated a plurality of times, the third speed V_{load} is gradually reduced each time like V_{load1} → V_{load2} → ... In such a case, how far the third speed V_{load} can be reduced can also be used as an index for margin evaluation.

### (Third modification)

The evaluation system 100 according to a third modification of the foregoing embodiment will be described. The evaluation system 100 according to the third modification includes a speed calculation apparatus 5C that has a configuration different from that of the foregoing speed calculation apparatus 5.

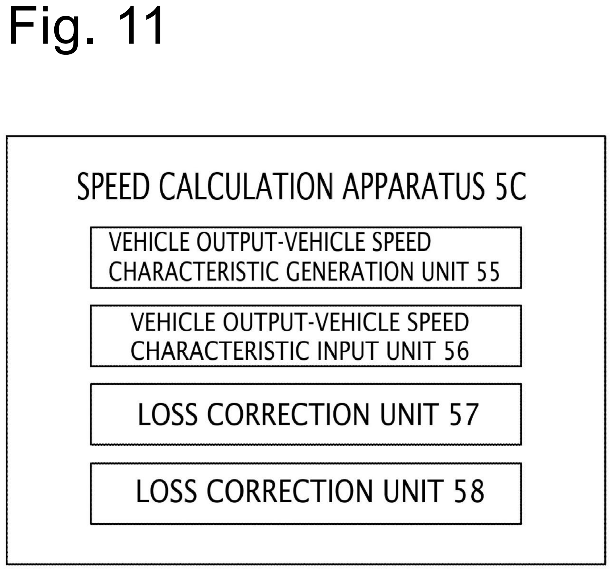

As shown in Fig. 11, the speed calculation apparatus 5C includes a vehicle output-vehicle speed characteristic generation unit 55, a vehicle output-vehicle speed characteristic input unit 56, a loss correction unit 57, and a speed calculation unit 58.

The vehicle output-vehicle speed characteristic generation unit 55 generates a vehicle output-vehicle speed characteristic indicating the relationship between the running speed V of the vehicle 200 and the output Pc of the vehicle 200 corresponding to the running speed V, which is obtained by running the vehicle 200 in a preliminary running test. The vehicle output-vehicle speed characteristic acquired here is data obtained under the test conditions (test environment and other conditions) of the foregoing preliminary running test, and the data can differ depending on the test conditions of the preliminary running test. The test conditions of the foregoing preliminary running test are just an example for identifying the vehicle output-vehicle speed characteristic that serves as a reference for margin evaluation, and other test conditions may be set for the preliminary running test. If the vehicle output-vehicle speed characteristic is available in advance, the vehicle output-vehicle speed generation unit 55 may be omitted.

The vehicle output-vehicle speed characteristic input unit 56 inputs the foregoing vehicle output-vehicle speed characteristic. If the vehicle output-vehicle speed characteristic is available in advance, the vehicle output-vehicle speed characteristic may be manually input by the person who conducts the running test, for example.

The loss correction unit 57 calculates a motor output-vehicle speed characteristic by correcting the foregoing vehicle output-vehicle speed characteristic based on a mechanical loss component due to driving loss and the like of the vehicle 200. The correction value based on the loss component of the vehicle 200 is obtained by performing a second preliminary running test in advance, and input and stored in the loss correction unit 57.

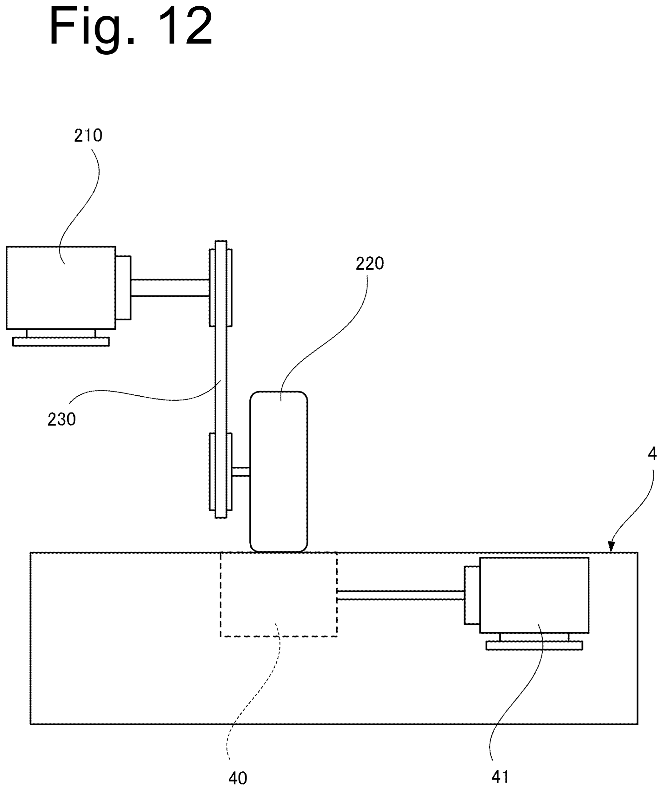

Specifically, in the second preliminary running test, as shown in Fig. 12, the tire 220 is rotated with the roller 40 of the running test apparatus 4 by driving the roller 40 using the measurement electric motor 41, with the power supply input terminals of the motor 210 open (disconnected from the battery). The speed characteristic of power needed in idling the motor 210 is thus calculated as driving loss. This driving loss is a loss component that derives mainly from a drive train 230 of the vehicle 200. The loss correction unit 57 determines the correction value based on the loss component.

The loss component-based correction does not necessarily need to be based on the foregoing second preliminary running test, and correction may be made by multiplying the vehicle output-vehicle speed characteristic by a constant correction value (or adding a constant correction value thereto).

The speed calculation unit 58 calculates the first speed Vₘᵢₙ and the second speed Vₘₐₓ that are the evaluation output corresponding speeds from the motor output-vehicle speed characteristic obtained through the foregoing correction of the loss component.

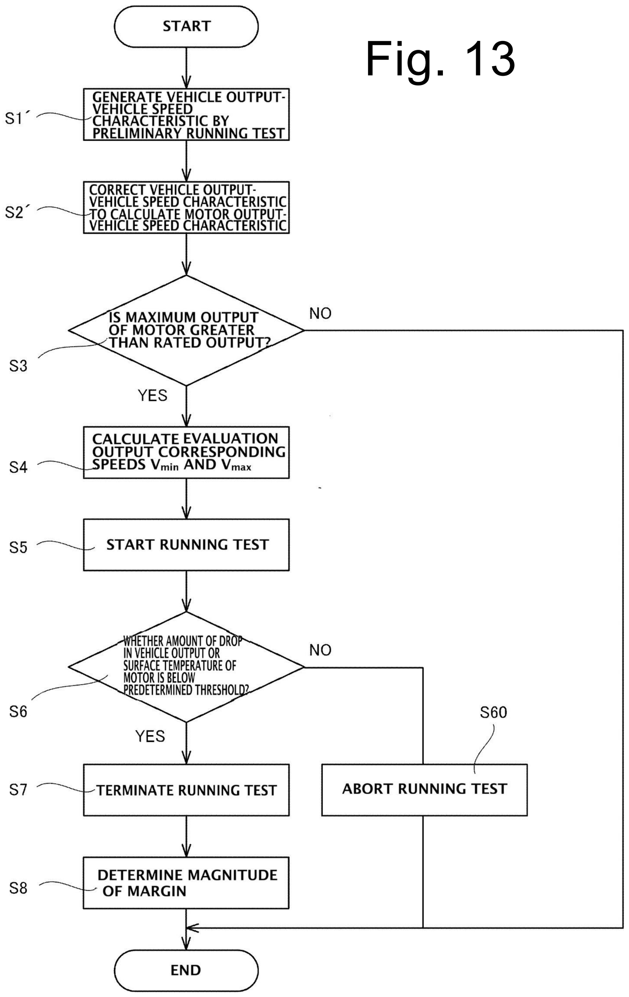

Fig. 13 shows a procedure for determining the magnitude of margin relative to the rated output Pr of the motor 210 when such a speed calculation apparatus 5C is employed. Specifically, step S1' of generating the vehicle output- vehicle speed characteristic by a preliminary running test and step S2' of correcting the vehicle output-vehicle speed characteristic to calculate the motor output-vehicle speed characteristic are performed before step S3 of determining whether the motor 210 has an output higher than the rated output Pr from the motor output-vehicle speed characteristic.

Employing such a speed calculation apparatus 5C enables calculation of the first speed Vₘᵢₙ and the second speed Vₘₐₓ that are the evaluation output corresponding speeds even if information about the specifications (such as the foregoing motor output-number of rotations characteristic) of the motor 210 is not available from the manufacturer and the like of the motor 210.

It will be understood that the present invention is not limited to the foregoing embodiments, and various changes may be made without departing from the gist of the present invention. For example, a test apparatus that drives the motor 210 alone may be prepared instead of the running test apparatus 4, and the margin relative to the rated output Pr may be evaluated with the motor 210 alone.

Instead of determining the margin based on the amount of drop in the output Pc or Pm, the margin may be determined to be large if the surface temperature Ts of the motor 210 is lower than a predetermined threshold, and small if the surface temperature Ts of the motor 210 is higher than or equal to the predetermined threshold.

The present invention also encompasses a motor evaluation index presentation apparatus including the temperature measurement device 1 and/or the output measurement device 2 described above, and the margin data generator 3a configured to generate and output margin determination data (data on the amount of drop in the output Pc or Pm and/or data on the surface temperature Ts of the motor 210) for determining the magnitude of the margin. In other words, while the evaluation system 100 having the foregoing configuration performs up to the "evaluation" of the margin, the present invention is not limited thereto. Other techniques may be employed, such as the motor evaluation index presentation apparatus presents an evaluation index for margin evaluation while the evaluation itself of the margin is made by a human operator.

According to the present invention, the output margin of a motor can be evaluated using a simple structure and technique.

### Reference Signs List

- 1: temperature measurement device
- 2: output measurement device
- 3a: margin data generator
- 3: margin determination apparatus
- 4: running test apparatus
- 5, 5C: speed calculation apparatus
- 30: temperature data acquisition unit
- 31: output data acquisition unit
- 32: determination unit
- 33: stop instruction unit
- 34: test nonexecution instruction unit
- 49: vehicle speed-number of rotations characteristic generation unit
- 50: vehicle speed-number of rotations characteristic input unit
- 51: motor output-number of rotations characteristic input unit
- 52: motor output-vehicle speed characteristic generation unit
- 53: speed calculation unit
- 55: vehicle output-vehicle speed characteristic generation unit
- 56: vehicle output-vehicle speed characteristic input unit
- 57: loss correction unit
- 58: speed calculation unit
- 100: motor output evaluation system
- 200: vehicle
- 210: electric motor (motor)
- D1: first test stage
- D2: second test stage
- D3: third test stage
- Pc: output of vehicle
- Pm: output of motor
- Pr: rated output
- Pth: output threshold
- Ts: surface temperature
- Tth: temperature threshold
- V: running speed
- V_{load}: third speed
- Vₘₐₓ: second speed
- Vₘᵢₙ: first speed
- t: test time

## Claims

1. A motor evaluation index presentation apparatus for presenting an evaluation index for evaluating an output (Pm) (hereinafter, evaluation target output) of an electric motor (210) mounted on a vehicle (200), the motor evaluation index presentation apparatus **characterized by** comprising:
an output measurement device (2) configured to measure the output (Pm) of the electric motor (210) or an output (Pc) of the vehicle (200) on which the electric motor (210) is mounted, and/or a temperature measurement device (1) configured to measure surface temperature of the electric motor (210); and
a margin data generator (3a) configured to generate and output margin determination data for determining magnitude of margin relative to the evaluation target output of the electric motor (210), wherein
the margin data generator (3a) is configured to, after the electric motor (210) is driven in an output range including the evaluation target output for a predetermined time (hereinafter, test time (t)),
generate data on an amount of drop in the output (Pm) of the electric motor (210) or the output (Pc) of the vehicle (200) on which the electric motor (210) is mounted as the margin determination data if the output measurement device (2) is included, and
generate data on the surface temperature of the electric motor (210) as the margin determination data if the temperature measurement device (1) is included.

2. A motor output evaluation system (100) for evaluating an output (Pm) (hereinafter, evaluation target output) of an electric motor (210) mounted on a vehicle (200), the motor output evaluation system (100) **characterized by** comprising:
the motor evaluation index presentation apparatus according to claim 1; and
a margin determination apparatus (3) configured to determine magnitude of the margin, wherein:
the motor evaluation index presentation apparatus includes the output measurement device (2); and
the margin determination apparatus (3) includes:
a margin determination data acquisition unit (31) configured to acquire the margin determination data; and
a determination unit (32) configured to refer to the margin determination data, and if the amount of drop in the output (Pm or Pc) of the electric motor (210) or the vehicle (200) on which the electric motor (210) is mounted is less than a predetermined threshold (hereinafter, output threshold (Pth)), determine that the margin is large, and if the amount of drop in the output (Pm or Pc) of the electric motor (210) or the vehicle (200) on which the electric motor (210) is mounted is greater than or equal to the output threshold (Pth), determine that the margin is small.

3. A motor output evaluation system (100) for evaluating an output (hereinafter, evaluation target output) of an electric motor (210) mounted on a vehicle (200), the motor output evaluation system (100) **characterized by** comprising:
the motor evaluation index presentation apparatus according to claim 1; and
a margin determination apparatus (3) configured to determine magnitude of the margin, wherein:
the motor evaluation index presentation apparatus includes the temperature measurement device (1); and
the margin determination apparatus (3) includes:
a margin determination data acquisition unit (31) configured to acquire the margin determination data; and
a determination unit (32) configured to refer to the margin determination data, and if a value of the surface temperature of the electric motor (210) is less than a predetermined threshold (hereinafter, temperature threshold (Tth)), determine that the margin is large, and if the value of the surface temperature of the electric motor (210) is greater than or equal to the temperature threshold (Tth), determine that the margin is small.

4. The motor output evaluation system (100) according to claim 2, **characterized in that** the margin determination apparatus (3) further includes a stop instruction unit (33) configured to, if the amount of drop in the output (Pm or Pc) of the electric motor (210) or the vehicle (200) on which the electric motor (210) is mounted reaches or exceeds the output threshold (Pth) before a lapse of the test time (t), determine that the margin is small, and issue an instruction to stop driving the electric motor (210).

5. The motor output evaluation system (100) according to claim 3, **characterized in that** the margin determination apparatus (3) further includes a stop instruction unit (33) configured to, if the value of the surface temperature of the electric motor (210) reaches or exceeds the temperature threshold (Tth) before a lapse of the test time (t), determine that the margin is small, and issue an instruction to stop driving the electric motor (210).

6. The motor output evaluation system (100) according to claim 2, **characterized by** further comprising a running test apparatus (4) configured to run the vehicle (200), wherein:
the output measurement device (2) is configured to measure the output (Pc) of the vehicle (200); and
the margin determination data is data on the amount of drop in the output (Pc) of the vehicle (200) when a running test where the vehicle (200) is run at a speed to exhibit the evaluation target output (hereinafter, evaluation output corresponding speed) for the test time (t) is performed using the running test apparatus (4).

7. The motor output evaluation system (100) according to claim 3, **characterized by** further comprising a running test apparatus (4) configured to run the vehicle (200), wherein
the margin determination data is data on the surface temperature of the electric motor (210) when a running test where the vehicle (200) is run at a speed to exhibit the evaluation target output (hereinafter, evaluation output corresponding speed) for the test time (t) is performed using the running test apparatus (4).

8. The motor output evaluation system (100) according to claim 6 or 7, **characterized in that** the running test includes running the vehicle (200) at a first speed (Vₘᵢₙ) and a second speed (Vₘₐₓ), the first speed (Vₘᵢₙ) being a lower one of the evaluation output corresponding speed, the second speed (Vₘₐₓ) being a higher one of the evaluation output corresponding speed.

9. The motor output evaluation system (100) according to claim 8, **characterized in that** the running test includes a first test stage (D1) where the vehicle (200) continues to be run at the second speed (Vₘₐₓ) for a predetermined time, a second test stage (D2) where the vehicle (200) continues to be run at the first speed (Vₘᵢₙ) for a predetermined time and then continues to be run at the second speed (Vₘₐₓ) for a predetermined time, and a third test stage (D3) where the vehicle (200) continues to be run at the first speed (Vₘᵢₙ) for a predetermined time.

10. The motor output evaluation system (100) according to claim 6 or 7, **characterized in that** the running test alternates a test at the evaluation output corresponding speed and a test at a third speed (V_{load}) lower than the evaluation output corresponding speed.

11. The motor output evaluation system (100) according to claim 10, **characterized in that:**
the evaluation output corresponding speed in the running test includes a lower first speed (Vₘᵢₙ) and a higher second speed (Vₘₐₓ); and
the third speed (V_{load}) is a speed between the first speed (Vₘᵢₙ) and the second speed (Vₘₐₓ).

12. The motor output evaluation system (100) according to claim 6 or 7, **characterized by** further comprising a speed calculation apparatus (5) configured to calculate the evaluation output corresponding speed to be used in the running test, wherein
the speed calculation apparatus (5) includes:
a vehicle speed-number of rotations characteristic input unit (49) configured to input a vehicle speed-number of rotations characteristic indicating a relationship between a running speed of the vehicle (200) and a number of rotations of the electric motor (210), the relationship being obtained by running the vehicle (200) using the running test apparatus (4);
a motor output-number of rotations input unit (51) configured to input a motor output-number of rotations characteristic indicating a relationship acquired in advance between the output (Pm) of the electric motor (210) and the number of rotations of the electric motor (210);
a motor output-vehicle speed characteristic generation unit (52) configured to generate a motor output-vehicle speed characteristic indicating a relationship between the output (Pm) of the electric motor (210) and the running speed of the vehicle (200) from the vehicle speed-number of rotations characteristic and the motor output-number of rotations characteristic; and
a speed calculation unit (53) configured to calculate the evaluation output corresponding speed from the motor output-vehicle speed characteristic.

13. The motor output evaluation system (100) according to claim 6 or 7, **characterized by** further comprising a speed calculation apparatus (5C) configured to calculate the evaluation output corresponding speed to be used in the running test, wherein
the speed calculation apparatus (5C) includes:
a vehicle output-vehicle speed characteristic input unit (56) configured to input a vehicle output-vehicle speed characteristic indicating a relationship between the output (Pc) of the vehicle (200) and a running speed of the vehicle (200), the relationship being obtained by running the vehicle (200) using the running test apparatus (4);
a loss correction unit (57) configured to calculate a motor output-vehicle speed characteristic by correcting the vehicle output-vehicle speed characteristic based on a driving loss component of the vehicle (200); and
a speed calculation unit (58) configured to calculate the evaluation output corresponding speed from the motor output-vehicle speed characteristic.

14. The motor output evaluation system (100) according to claim 6 or 7, **characterized in that** the margin determination apparatus (3) further includes a test nonexecution instruction unit (34) configured to refer to a motor output-vehicle speed characteristic indicating a relationship between the output (Pm) of the electric motor (210) and the running speed of the vehicle (200), and if a maximum output (Pm) of the electric motor (210) is less than or equal to the evaluation target output, determine that the margin is small, and issue an instruction to not execute the running test.

15. A motor evaluation index presentation method for presenting an evaluation index for evaluating an output (Pm) (hereinafter, evaluation target output) of an electric motor (210) mounted on a vehicle (200), the motor evaluation index presentation method **characterized by** comprising:
an output measurement step of measuring the output (Pm) of the electric motor (210) or an output (Pc) of the vehicle (200) on which the electric motor (210) is mounted, and/or a temperature measurement step of measuring surface temperature of the electric motor (210); and
a margin data generation step of generating and outputting margin determination data for determining magnitude of margin relative to the evaluation target output of the electric motor (210), wherein
in the margin data generation step after the electric motor (210) is driven in an output range including the evaluation target output for a predetermined time (hereinafter, test time (t)),
data on an amount of drop in the output (Pm) of the electric motor (210) or the output (Pc) of the vehicle (200) on which the electric motor (210) is mounted is generated as the margin determination data if the output measurement step is included, and
data on the surface temperature of the electric motor (210) is generated as the margin determination data if the temperature measurement step is included.
